# EUROPÄISCHE PATENTSCHRIFT

(11) **EP 0 887 438 B1**
(45) Veröffentlichungstag und Bekanntmachung des Hinweises auf die Patenterteilung: **17.10.2001**
(21) Anmeldenummer: 98110893.9
(22) Anmeldetag: 13.06.1998
(51) Int. Cl.: C23C 16/50

(54) **Verfahren zur Oberflächenvergütung innerer Oberflächen von Hohlkörpern und Vorrichtung zur Durchführung des Verfahrens**
Process for improving the inner surface of hollow bodies and device for carrying out the process
Procédé d'amélioration de la surface inférieure de corps creux et dispositif de la mise en oeuvre du procédé

(30) Priorität: 23.06.1997 DE 19726443
(43) Veröffentlichungstag der Anmeldung: 30.12.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: Jung, Thomas, Dr., 38173 Hötzum (DE); Hellmich, Anke, 63741 Aschaffenburg (DE)
(74) Vertreter: Einsel, Martin, Dipl.-Phys.

(56) Entgegenhaltungen:
- EP-A1- 0 727 508
- DE-A1- 4 235 953

## Beschreibung

Die Erfindung betrifft ein Verfahren zur Oberflächenvergütung innerer Oberflächen von Hohlkörpern mit zumindest einer Öffnung und eine Vorrichtung zur Durchführung des Verfahrens.

Verfahren zur Vergütung von inneren Oberflächen von Hohlkörpern sind bekannt. Beispielsweise wird hierbei eine Beschichtung mittels eines thermischen chemischen Gasphasenabscheideverfahrens, dem Chemical Vapor Deposition-Verfahren (CVD), vorgesehen. Auch ist die Nutzung eines Mikrowellenplasmas zur Abscheidung von CVD-Schichten im Rahmen eines Plasma Impulse Chemical Vapor Deposition-Verfahrens (PICVD) bekannt. Dies Verfahren wird zur Beschichtung von optischen Elementen, wie Laserspiegeln, Kaltlicht-Spiegelreflektoren für Halogenlampen etc. eingesetzt. Aufgrund der thermischen Stabilität und Resistenz gegen Umgebungseinflüsse haben sich solche Beschichtungen in chemischen Anwendungen bewährt, wie bei diffusionshemmenden Beschichtungen auf Glasbehältnissen für die Pharmazie.

Bei dem PICVD-Verfahren ist eine Gasentladung in einem Vakuumgefäß vorgesehen. Eine übliche Betriebsbedingung ist dabei ein Vakuum in einem Bereich von 1 mbar. Für die Beschichtung wird eine Mikrowellenfrequenz von 2,45 GHz vorgesehen. Für beispielsweise die Beschichtung von Spiegeln von Kaltlicht-Lampen werden dabei Beschichtungen aus SiO₂ und TiO₂ vorgesehen. Bei dem PICVD-Verfahren liegen die Aktivierungstemperaturen niedriger als bei dem CVD-Verfahren, da mittels Mikrowellen gezündet wird.

Das CVD-Verfahren weist einen Gaseinlaß, ein Vakuumgefäß und eine Heizquelle auf. Entweder wird bei Normaldruck ohne eine Pumpe gearbeitet oder bei Niederdruck im mbar-Bereich mit einer Pumpe und unter Beachtung von Druckstabilität. Die Gleichgewichtsprozesse laufen dabei bei Temperaturen von ca. 1.000° C ab.

Bei dem PICVD-Verfahren muß das Plasma in der Nähe der Beschichtungsstelle brennen. Das Behältnis, welches beispielsweise auf der Innenseite beschichtet werden soll, muß für die entsprechenden Wellenlängen der Mikrowellen transparent bzw. durchstrahlbar sein.

Eine Vergütung von inneren Oberflächen von Hohlkörpern wird u.a. in der optischen, metallurgischen, Elektro- oder Halbleiterindustrie eingesetzt. Ziel der Oberflächenvergütung ist dabei beispielsweise ein Verschleißschutz, Reibminderung, Verringerung von Klebneigung, Korrosionsschutz und anderes. Oberflächenvergütet werden dabei beispielsweise Düsen, Umformwerkzeuge, Halbzeuge, Rohre oder dergleichen. Derartige Hohlkörper können aus Metall, Glas, Keramik oder Kunststoffen bestehen.

Bei den bekannten thermischen CVD-Verfahren wird für das Abscheideverfahren nachteilig eine hohe Abscheidetemperatur benötigt, wodurch die Auswahl der beschichtbaren Materialien stark eingeschränkt ist. Viele Schichtsysteme, insbesondere verschleißfeste Schichten, benötigen zum Erreichen der angestrebten Morphologie einen lonenbeschuß, der bei den thermischen CVD-Verfahren nicht möglich ist.

Bei dem PICVD-Verfahren besteht die Notwendigkeit, eine Mikrowellenanregung zu nutzen. Diese jedoch ist teuer und eine Einkopplung in beispielsweise Metall ist wie oben beschrieben nicht möglich.

Bekannt ist auch eine physikalische Gasphasenabscheidung in Form des Physical Vapor Deposition -(PVD)-Verfahrens, bei der eine Vergütung durch Aufdampfen, Sputtern oder lonenplattieren geschieht. Das PVD-Verfahren arbeitet mit niedrigeren Temperaturen als das CVD-Verfahren und eignet sich besonders für die Vergütung optischer Bauteile. Ein Vergüten von inneren Oberflächen eines Hohlkörpers geschieht mittels des PVD-Verfahrens mit einem Draht und einem Laser, oder aber wie in der JP 63-137167 A vorgeschlagen mit einem lonenstrahl. Die Drahtspitze wird durch den Laser (bzw. den lonenstrahl) geschmolzen und verdampft. Voraussetzung dafür ist ein gerader Hohlkörper ohne Biegungen. Nachteilig erweist sich dieses Verfahrens aber auch durch seine hohen Kosten aufgrund des Laser- bzw. lonenstrahleinsatzes sowie durch die Gefahr einer Tröpfchenbildung im Randbereich. Der Einsatz des lonenstrahls wird auch als lonenstrahlsputtern bezeichnet.

In der JP 63-26373 A wird ein Rohr als Hohlkörper dadurch beschichtet, daß eine Hohlkathodenglimmentladung stattfindet, wobei der Hohlkörper selbst die Kathode ist. Nachteilig ist, daß nur Rohre größeren Durchmessers in völlig gerader Ausbildung innen beschichtet werden können und daß nach einiger Zeit bei einer Beschichtung mit einer isolierenden Schicht die Entladung abbricht. Außerdem wird das für die Hohlkathodenbeschichtung eingesetzte Rohr zugleich unbeabsichtigt mitbeschichtet.

In der DD 294 511 A5 wird ebenfalls eine Hohlkathodenglimmentladung zur Innenbeschichtung von Rohren vorgeschlagen. Dabei findet ein PVD-Verfahren Verwendung, die Quelle wird in das Rohr eingeschoben und der Hohlraum im Inneren des Rohres bildet gleichzeitig eine Vakuumkammer. Erforderlich ist eine Relativquelle, da sonst nur lokale Beschichtungen stattfinden, außerdem können nur relativ große Hohlräume beschichtet werden, die außerdem rohrförmig sein müssen.

Der Erfindung liegt daher die Aufgabe zugrunde, ein Verfahren und eine Vorrichtung zu schaffen, durch die unabhängig von dem verwendeten Material und der Form des Hohlkörpers allgemein eine Oberflächenvergütung der inneren Oberfläche des Hohlkörpers störungsfrei geschehen kann.

Die Aufgabe wird durch ein Verfahren gelöst, bei dem der Hohlkörper von innen durch eine Hohlkathodenglimmentladung als Anregungsquelle vergütet wird, und durch einen durch den Hohlkörper strömenden Gasstrom aus einem bei der Hohlkathodenglimmentladung sich bildenden Plasma Teilchen herausgelöst, angeregt und zu der inneren Oberfläche des Hohlkörpers transportiert werden und dort den Vergütungsprozeß auslösen, wobei der Hohlkörper in einem Vakuumgefäß angeordnet wird, und der Hohlkörper und die Hohlkathode zu voneinander getrennte Elemente bilden.

Durch eine Vorrichtung nach Anspruch 13 wird die der Erfindung zugrunde liegende Aufgabe gelöst. Weiterbildungen der Erfindungen sind in den jeweiligen Unteransprüchen 1 bis 12 und 14 bis 21 definiert.

Dadurch wird ein Verfahren und eine Vorrichtung zur Oberflächenvergütung innerer Oberflächen von Hohlkörpern mit zumindest einer Öffnung geschaffen, bei denen unabhängig von dem verwendeten Material und der Form des Hohlkörpers allgemein eine Oberflächenvergütung der inneren Oberfläche des Hohlkörpers erfolgen kann. Diese Oberflächenvergütung kann dabei mit hoher Rate erfolgen, wobei diese Rate derjenigen entspricht, die auf planaren Substraten bei Anregungen mittels Hohlkathodenglimmentladung erreicht werden kann. Die Rate liegt vorzugsweise im Bereich von 1 bis 100 µm/Std.; zum Vergleich: beim CVD-Verfahren werden sonst nur wenige µm/Std., beim PVD-Verfahren bis zu 10 µm/Std. erzielt. Das übliche PVD-Verfahren eignet sich weniger für die Vergütung von Hohlräumen, da im allgemeinen dabei ein Rückgang der Schichtwachstumsrate zu verzeichnen ist.

Vorzugsweise wird die Vergütung mittels CVD- oder PVD-Verfahrens oder mittels Plasmadiffusion oder Plasma- oder lonenätzverfahrens durchgeführt, wodurch entweder eine Beschichtung aufgetragen oder Material abgetragen wird. Plasmaabtrag bzw. -diffusion dient dem Reinigen, Ätzen, Nitrieren, Carbonitrieren oder einfach Aktivieren, wobei Oberflächenschichten abgestäubt oder oxidiert oder reduziert oder N₂ oder C in die Oberfläche eindiffundiert wird. Es kann also bei dem erfindungsgemäßen Verfahren sowohl nur mit einem Reaktivgas (CVD) als auch nur mit Metallen (PVD) eine Vergütung erzeugt werden.

Vorzugsweise wird die Hohlkathode von einem Gasstrom durchströmt, besonders bevorzugt von einem Inertgas. Hier kann vorzugsweise Argongas verwendet werden. Der Inertgasstrom fungiert dabei dann als Transportmittel für die schichtbildenden Teilchen oder für die an der Oberfläche des Hohlkörpers reagierenden Teilchen. Er dient somit der Steuerung des Materialflusses.

Besonders bevorzugt wird der von innen zu vergütende Hohlkörper entweder auf die Anregungsquelle der Hohlkathodenglimmentladung und die Gaszuführungen so aufgesetzt, daß die Gase und Teilchen in den Hohlkörper strömen. Oder es wird die Hohlkathode in den zu vergütenden Hohlkörper eingeschoben. Die in den Hohlkörper einströmenden Teilchen sind entweder Bestandteil des Inertgases, eines Reaktivgases oder sie sind abgesputterte Kathodenatome der Hohlkathode.

Die zu vergütenden Hohlkörper weisen beispielsweise einen Innendurchmesser von 1 mm bis 100 mm auf. Sie können vorteilhaft jede beliebige Form aufweisen, insbesondere ein Winkelrohr oder kompliziert geformtes Hohlelement sein.

Besonders bevorzugt wird die Hohlkathode gekühlt. Aufgrund des hohen Energieumsatzes zum Erzielen einer höheren Schichtrate könnte die Hohlkathode ohne zusätzliche Kühlung nach einer gewissen Zeit zerstört werden. Um diese Zerstörung zu verhindern, kann alternativ zur Kühlung auch ein Impulsbetrieb in Form eines Plasmaimpulses vorgesehen werden. Dabei wird die Hohlkathode nur kurzzeitig betrieben. Es kann dann jedoch zum Teil nur eine begrenzte Schichtdicke erzielt werden.

Die Wahl der Schicht ist zweckabhängig, beispielsweise wird Titannitrid bevorzugt verwendet. Die Verfahrenstemperatur beträgt dabei 300° bis 500° C. Amorphe Kohlenstoffe graphitisieren bereits bei Temperaturen größer als 200° C. Durch die Beschichtungsquelle findet ein Leistungseintrag statt, welcher den Vorgang in einer bestimmten Temperatur münden läßt. Um hier gegensteuern zu können, wird bevorzugt eine Kühlung oder ein Heizen vorgesehen.

Besonders bevorzugt herrscht in dem den Hohlkörper und die Hohlkathode umgebenden Vakuumgefäß ein Druck von etwa 0,1 mbar bis etwa 100 mbar. Dadurch kann ein stabiles Brennen des jeweiligen Entladungstyps gewährt werden.

Zur näheren Erläuterung der Erfindung werden im folgenden Ausführungsbeispiele einer erfindungsgemäßen Vorrichtung zur Oberflächenvergütung innerer Oberflächen von Hohlkörpern mit zumindest einer Öffnung anhand der Zeichnungen näher beschrieben. Diese zeigen in:
- **Figur 1**: eine Schnittansicht einer ersten Ausführungsform einer erfindungsgemäßen Vorrichtung, bei der die Hohlkathode außerhalb des zu vergütenden Hohlkörpers angeordnet ist,
- **Figur 2**: eine Prinzipskizze einer zweiten Ausführungsform einer erfindungsgemäßen Vorrichtung, bei der die Hohlkathode in den innen zu beschichtenden Hohlkörper eingeschoben ist, und
- **Figur 3**: eine Prinzipskizze einer dritten Ausführungsform einer erfindungsgemäßen Vorrichtung, bei der die Hohlkathode außerhalb des zu vergütenden Hohlkörpers angeordnet ist.

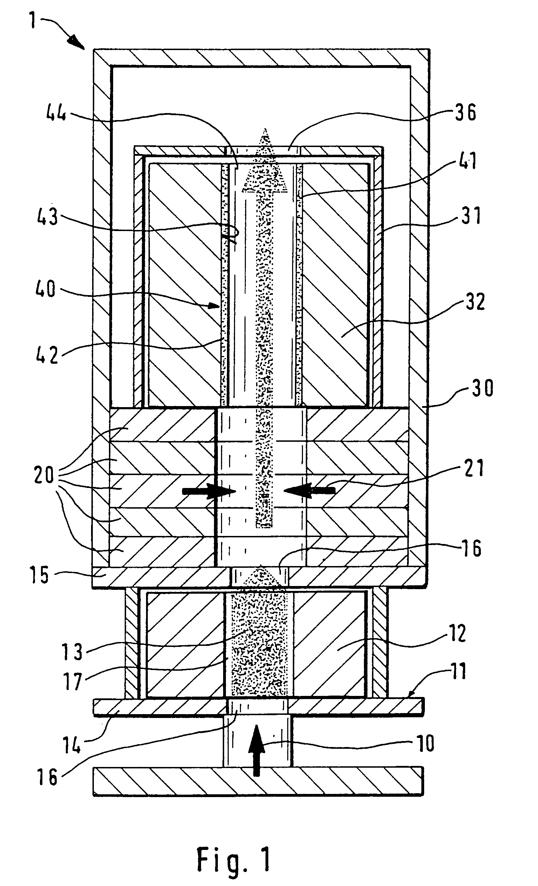

In **Figur 1** ist eine Prinzipskizze einer Schnittansicht einer ersten Ausführungsform einer erfindungsgemäßen Vorrichtung 1 dargestellt. Im unteren Bereich der Vorrichtung 1 ist eine Gaszuführung 10 für Inertgas vorgesehen. Über dieser Inertgaszuführung ist ein Gehäuse 11 angeordnet. Das Gehäuse 11 weist an seiner Unterseite und an seiner Oberseite 14, 15 jeweils miteinander fluchtende Öffnungen 16 auf.

In dem Gehäuse 11 ist ein Rohrtarget einer Hohlkathode 12 vorgesehen.

Auf der Oberseite 15 des Gehäuses 11 ist ein Vakuumgefäß 30 mit darin vorgesehenen Abstandsringen 20 aufgefügt. Diese dienen zum Schaffen eines Abstandes zu einem Substrathalter 32, welcher oberhalb der Öffnungen 16 mit seinen Öffnungen 36 vorgesehen ist. Die Abstandsringe 20 weisen eine Gaszuführung 21 für Zusatzgas als Reaktivgas auf. Diese kann beispielsweise als Ringdüse gebildet sein. Dadurch wird das in dieser Ringdüse strömende Gas gleichmäßig entlang am Umfang der Abstandsringe 20 verteilt.

Innerhalb des Vakuumgefäßes 30 ist zunächst eine Abschirmung 31 vorgesehen. Innerhalb dieser Abschirmung 31 ist ein Substrathalter 32 angeordnet. Dieser trägt ein Substrat oder aber einen Hohlkörper 40 ohne oder mit dem Substrat 41. Es kann also entweder ein Hohlkörper ohne Substrat vergütet werden oder ein solcher mit Substrat oder, beispielsweise zu Testzwecken, ein Substrat allein, welches anschließend dem Halter entnommen und separat auf das Vergütungsergebnis untersucht werden kann. Auf der inneren Oberfläche 43 des Hohlkörpers 40 soll letztendlich eine Beschichtung 42 aufgetragen oder eine Vergütung vorgesehen werden.

Zu diesem Zweck wird ein Inertgas, beispielsweise Argongas, durch die Inertgaszuführung 10 geschickt. Das Inertgas gelangt von der Unterseite 14 des Gehäuses 11 her durch die Öffnung 16 in den Innenraum 17 der Hohlkathode 12. Bei der Hohlkathodenglimmentladung entsteht nachfolgend dann ein Plasma 13 in diesem Innenraum 17. Aufgrund der Gaszufuhr des Inertgases von der Unterseite des Gehäuses her wird das Plasma in Richtung zu der oberen Öffnung 16 in der Oberseite 15 des Gehäuses 11 hin in Bewegung versetzt.

Im Bereich der Abstandsringe 20 gelangt durch die Gaszuführung 21 ein Zusatzgas zu dem Plasma 13 hinzu. Um keine Diffusion des Zusatzgases in die Hohlkathode hinein zu bekommen, sind die Abstandsringe vorgesehen. Gase und Plasma strömen in den Hohlkörper 40 hinein und bilden auf dessen innerer Oberfläche 43 die Beschichtung 42.

Das Gemisch aus Plasma und Zusatzgas als Reaktivgas gelangt auf der Oberseite des Hohlkörpers durch dessen obere Öffnung 44 und die Öffnung 36 der Abschirmung 31 wieder aus dem Hohlkörper heraus.

Die Oberfläche 43 des Hohlkörpers 40 wird mittels dieser Vorrichtung also nur durch Plasmateilchen und das Zusatzgas beschichtet. Dabei schlagen sich Bestandteile des Gemisches aus Zusatzgas und Plasma als Schicht oder Schichtbestandteil auf der inneren Oberfläche 43 des Hohlkörpers 40 nieder.

Um ein Überhitzen der Hohlkathode 12 zu verhindern, wird bei dieser vorzugsweise im Bereich des Rohrtargets eine Kühlung, welche in Figur 1 jedoch nicht dargestellt ist, vorgesehen.

Während der Oberflächenvergütung der inneren Oberfläche 43 des Hohlkörpers 40 kann dieser jedoch auch beheizt oder gekühlt werden. Hierbei ist auf den Zweck der Beschichtung auf dem Substrat einzugehen und abzustellen. Dabei kann beispielsweise aufgrund einer bestimmten Temperatur ein gewünschtes Beschichtungsergebnis erzielt werden.

Bei dem Vakuumgefäß 30 ist beispielsweise ein Druck von etwa 0,1 mbar bis etwa 100 mbar eingestellt, da hierbei die Ladung stabil brennt und sehr gute Beschichtungsergebnisse ermöglicht werden.

Die Hohlkathodenglimmentladung innerhalb der Hohlkathode kann durch Gleichspannung oder durch gepulste Gleichspannung oder aber durch Wechselspannung mit einer Frequenz von etwa 1 kHz bis 10 GHz bei einer vorgesehenen Spannung von etwa 200 V bis 2000 V gespeist werden. Alternativ oder zusätzlich hierzu kann aber auch die innere Oberfläche 43 des Hohlkörpers 40 gegenüber dem Plasma 13 innerhalb der Hohlkathode 12 auf ein negatives elektrisches Potential gelegt werden. Hierbei sind beispielsweise Werte von einigen 10 V bis einigen 100 V möglich. Aufgrund der Potentialdifferenz werden positiv geladene Teilchen aus dem Plasma 13 der Hohlkathode 12 oder aus einer durch das Plasma der Hohlkathode gestützten unselbständigen Ladung im Hohlraum des Hohlkörpers hin zu dessen innerer Oberfläche beschleunigt und damit die Oberflächenbeschichtung verstärkt.

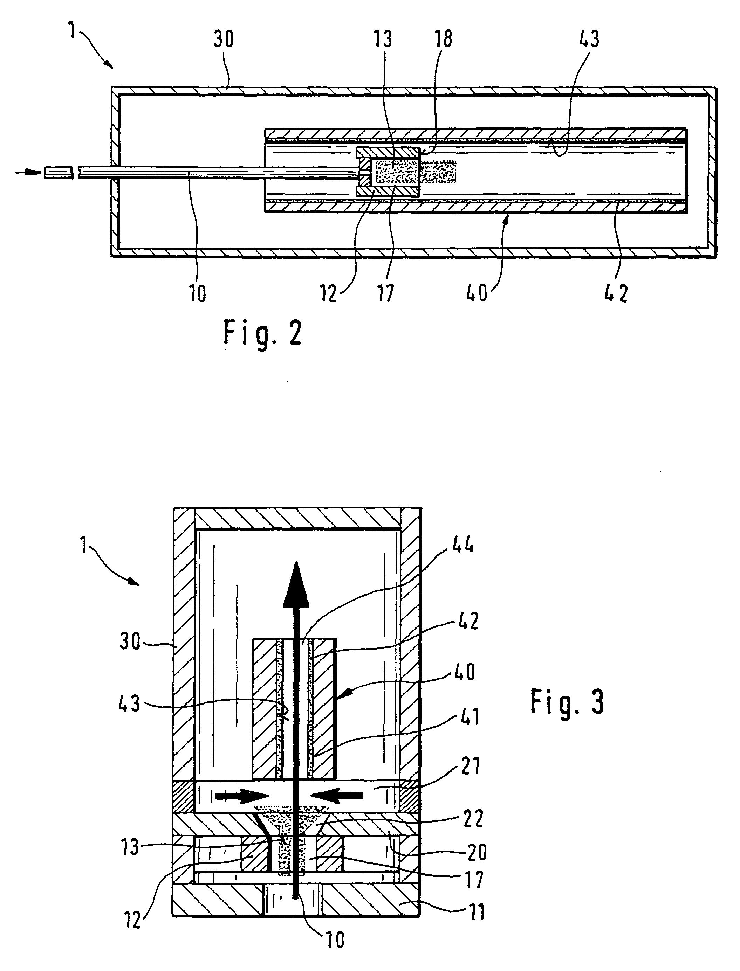

**Figur 2** zeigt eine zweite Ausführungsform einer erfindungsgemäßen Vorrichtung als Prinzipsskizze. Bei dieser Variante wird die Hohlkathode 12 mit der Gaszuführung 10 für Inertgas versehen. Diese ist vorzugsweise als steife Rohrleitung gebildet. Dadurch kann die Hohlkathode in den Hohlkörper 40 eingeschoben werden. Bei einem beispielsweise sehr langen Hohlkörper, beispielsweise bei einem Rohr, kann dadurch die Hohlkathode die gesamte Länge des Rohres auf der Innenseite vergüten.

Durch beispielsweise Inertgaszuführung wird eine Hohlkathodenglimmentladung innerhalb der Hohlkathode 12 erzeugt und dadurch das Plasma 13 gebildet. Dieses hat nun das Bestreben, auf der Oberseite 18 der Hohlkathode 12 den Innenraum 17 zu verlassen und in den Hohlkörper 40 einzutreten. Durch den Gasstrom wird das Plasma in einem größeren Bereich zur inneren Oberfläche des Hohlkörpers hin transportiert und bewirkt dort die Beschichtung oder Vergütung. Hier kann es entweder in die Oberfläche eindiffundieren oder Material von der Oberfläche abtragen. Ein solcher Materialabtrag geschieht vorzugsweise bei der Plasmadiffusion oder dem Plasma- oder lonenätzverfahren.

Bei der Ausführungsform gemäß Figur 2 wird die Oberfläche also dadurch vergütet, daß Plasmateilchen und insbesondere abgestäubtes Kathodenmaterial der Hohlkathode die Vergütung bewirken. Dieser Vorgang wird als Kathodenzerstäuben oder Sputtern bezeichnet.

Um möglichst sinnvolle Ergebnisse zu erzielen, weisen die Hohlkörper 40 vorzugsweise einen Innendurchmesser von 1 mm bis 100 mm auf. Bei größeren Innendurchmessern können auch andere bekannte Vergütungs- bzw. Beschichtungsverfahren verwendet werden. Bei einem Innendurchmesser von weniger als 1 mm ist der Herstellungsaufwand für eine entsprechend klein dimensionierte Hohlkathode, welche in den Hohlkörper noch eingeschoben werden kann, so groß, daß die Kosten im Zweifel dem Nutzen nicht Rechnung tragen.

In **Figur 3** ist eine dritte Ausführungsform einer erfindungsgemäßen Vorrichtung 1 als Prinzipsskizze dargestellt. Der Aufbau ähnelt dem der ersten Ausführungsform gemäß Figur 1. Lediglich die Formgebung der inneren Öffnung des Abstandsringes ist anders gewählt, nämlich trichterförmig. Dadurch wird das in dem Innenraum 17 der Hohlkathode 12 entstehende Plasma 13 auf eine grössere Fläche verteilt. Das weiter oben zuströmende Zusatzgas 21 kann sich dann einerseits besser mit dem Plasma vermischen und kann andererseits weniger leicht in die Hohlkathode einströmen. Dies liegt in dem in einem großen Winkelbereich ausströmenden Inertgas begründet.

Anstelle einer Inertgaszuführung kann alternativ auch ein anderes, für eine Hohlkathodenglimmentladung geeignetes Gas verwendet werden. Die Wahl des Zusatzgases als Reaktivgas ist abhängig von dem zu erzielenden Ergebnis auf dem Substrat, also von der gewünschten Beschichtung auf der bzw. Vergütung der inneren Oberfläche des Hohlkörpers.

### Bezugszeichenliste

- 1: Vorrichtung

- 10: Inertgaszuführung
- 11: Gehäuse
- 12: Rohrtarget der Hohlkathode
- 13: Plasma
- 14: Unterseite
- 15: Oberseite
- 16: Öffnungen
- 17: Innenraum
- 18: Oberseite

- 20: Abstandsringe
- 21: Gaszuführung für Zusatzgas
- 22: innere Öffnung

- 30: Vakuumgefäß
- 31: Abschirmung
- 32: Substrathalter
- 36: Öffnung

- 40: Hohlkörper
- 41: Substrat
- 42: Vergütung/Beschichtung
- 43: innere Oberfläche
- 44: obere Öffnung

## Patentansprüche

1. Verfahren zur Oberflächenvergütung innerer Oberflächen von Hohlkörpern mit zumindest einer Öffnung,
bei dem der Hohlkörper von innen durch eine Hohlkathodenglimmentladung als Anregungsquelle vergütet wird,
und durch einen durch den Hohlkörper strömenden Gasstrom aus einem bei der Hohlkathodenglimmentladung sich bildenden Plasma Teilchen herausgelöst, angeregt und zu der inneren Oberfläche des Hohlkörpers transportiert werden und dort den Vergütungsprozeß auslösen,
wobei der Hohlkörper in einem Vakuumgefäß angeordnet wird, und
der Hohlkörper und die Hohlkathode voneinander getrennte Elemente bilden.

2. Verfahren nach Anspruch 1,
**dadurch gekennzeichnet,**
**daß** die Oberflächenvergütung mittels Physical-Vapor-Deposition - (PVD) - oder Chemical-Vapor-Deposition - (CVD) - Verfahrens oder mittels Plasmadiffusion oder Plasma- oder lonenätzverfahrens geschieht.

3. Verfahren nach Anspruch 1 oder 2,
**dadurch gekennzeichnet,**
**daß** ein Inertgasstrom als Transportmedium für schichtbildende Teilchen oder an der inneren Oberfläche des Hohlkörpers reagierende Teilchen verwendet wird.

4. Verfahren nach einem der Ansprüche 1 bis 3,
**dadurch gekennzeichnet,**
**daß** der auf der inneren Oberfläche zu vergütende Hohlkörper auf die Anregungsquelle der Hohlkathodenglimmentladung und auf eine Gaszuführung so aufgesetzt wird, daß die Teilchen des durch die Hohlkathode strömenden Gases in den Hohlkörper gelangen.

5. Verfahren nach Anspruch 1, 2 oder 3,
**dadurch gekennzeichnet,**
**daß** eine Hohlkathode in den an seiner inneren Oberfläche zu vergütenden Hohlkörper eingeschoben wird.

6. Verfahren nach einem der vorstehenden Ansprüche,
**dadurch gekennzeichnet,**
**daß** eine Kathodenzerstäubung geschieht, wobei Teilchen von der Kathodenoberfläche der Hohlkathode abgetragen werden, und
**daß** die Teilchen durch den den Hohlkörper durchströmenden Gasstrom zu dessen innerer Oberfläche transportiert und dort abgeschieden werden.

7. Verfahren nach einem der vorstehenden Ansprüche,
**dadurch gekennzeichnet,**
**daß** ein Zusatzgas durch Diffusion oder Strömung zur inneren Oberfläche des Hohlkörpers gelangt,
**daß** Bestandteile aus dem Zusatzgas sich als Schicht oder Schichtbestandteil auf dessen innerer Oberfläche niederschlagen, in die innere Oberfläche eindiffundieren oder Material von der inneren Oberfläche abtragen, wobei sie zur Vergütung der inneren Oberfläche beitragen.

8. Verfahren nach einem der vorstehenden Ansprüche,
**dadurch gekennzeichnet,**
**daß** die Oberflächenvergütung durch Plasmateilchen und abgestäubtes Kathodenmaterial bewirkt wird.

9. Verfahren nach einem der vorstehenden Ansprüche,
**dadurch gekennzeichnet,**
**daß** die Hohlkathodenglimmentladung durch Gleichspannung, gepulste Gleichspannung oder Wechselspannung gespeist wird, bei der insbesondere eine Frequenz von im wesentlichen 1 kHz bis 10 GHz und eine Spannung von im wesentlichen 200 V bis 2 kV vorgehalten wird.

10. Verfahren nach einem der vorstehenden Ansprüche,
**dadurch gekennzeichnet,**
**daß** die innere Oberfläche des Hohlkörpers auf ein gegenüber dem Hohlkathodenplasma negatives elektrisches Potential gelegt wird, insbesondere auf ein Potential von im wesentlichen 10 V oder Vielfachem hiervon bis im wesentlichen 100 V oder Vielfachem hiervon.

11. Verfahren nach Anspruch 10,
**dadurch gekennzeichnet,**
**daß** positiv geladene Teilchen aus dem Hohlkathodenplasma gelöst werden oder aus einer durch das Hohlkathodenplasma gestützten unselbständigen Entladung entstehen, und
**daß** sie im Hohlkörper zu dessen innerer Oberfläche hin beschleunigt werden und die Oberflächenvergütung verstärken.

12. Verfahren nach einem der vorstehenden Ansprüche,
**dadurch gekennzeichnet,**
**daß** der Hohlkörper während der Oberflächenvergütung beheizt oder gekühlt wird, oder
**daß** die Hohlkathode während der Oberflächenvergütung gekühlt wird.

13. Vorrichtung zur Durchführung des Verfahrens nach einem der Ansprüche 1 bis 12,
**dadurch gekennzeichnet,**
**daß** eine Hohlkathode, eine Gaszuführung, ein Vakuumgefäß zur Aufnahme von Hohlkathode und zumindest einem Teil eines zu beschichtenden Hohlkörpers, eine Anode, eine Stromversorgung und im Betrieb ein Plasma vorgesehen sind.

14. Vorrichtung nach Anspruch 13,
**dadurch gekennzeichnet,**
**daß** ein den auf seiner inneren Oberfläche zu vergütenden Hohlkörper durchströmender Gasstrom und ein Zusatzgas vorgesehen sind.

15. Vorrichtung nach Anspruch 13,
**dadurch gekennzeichnet,**
**daß** die Hohlkathode im Inneren des Hohlkörpers angeordnet ist.

16. Vorrichtung nach Anspruch 13 oder 14,
**dadurch gekennzeichnet,**
**daß** die Hohlkathode außerhalb des Hohlkörpers angeordnet ist.

17. Vorrichtung nach einem der Ansprüche 13 bis 16,
**dadurch gekennzeichnet,**
**daß** eine Heizeinrichtung oder eine Kühleinrichtung zum Beheizen oder Kühlen des Hohlkörpers während der Oberflächenvergütung vorgesehen ist.

18. Vorrichtung nach einem der Ansprüche 13 bis 16,
**dadurch gekennzeichnet,**
**daß** eine Kühlung für die Hohlkathode vorgesehen ist.

19. Vorrichtung nach einem der Ansprüche 13 bis 18,
**dadurch gekennzeichnet,**
**daß** das die Hohlkathode durchströmende Gas ein Inertgas, insbesondere Argongas ist.

20. Vorrichtung nach einem der Ansprüche 13 bis 19,
**dadurch gekennzeichnet,**
**daß** in dem Vakuumgefäß ein Druck von im wesentlichen 0,1 mbar bis etwa 100 mbar vorgesehen ist.

21. Vorrichtung nach einem der Ansprüche 13 bis 20,
**dadurch gekennzeichnet,**
**daß** der zu vergütende Hohlkörper einen Innendurchmesser von 1 bis 100 mm aufweist.

## Claims

1. Process for surface-finishing inner surfaces of hollow bodies with at least one opening, in which the hollow body is finished from inside by means of a hollow-cathode glow discharge as the excitation source, and a gas stream flowing through the hollow body extracts particles from a plasma forming during the hollow-cathode glow discharge, excites them and transports them to the inner surface of the hollow body, where they initiate the finishing process, wherein the hollow body is disposed in a vacuum vessel, and the hollow body and the hollow cathode form elements which are separate from one another.

2. Process according to claim 1, **characterised in that** the surface-finishing takes place by means of physical vapour deposition - (PVD) - or chemical vapour deposition - (CVD) - or by means of plasma diffusion or plasma or ion etching.

3. Process according to claim 1 or 2, **characterised in that** an inert gas stream is used as the transport medium for film-forming particles or particles reacting-at the inner surface of the hollow body.

4. Process according to any one of claims 1 to 3, **characterised in that** the hollow body to be finished on the inner surface is positioned on the excitation source of the hollow-cathode glow discharge and on a gas supply such that the particles of the gas flowing through the hollow cathode enter the hollow body.

5. Process according to claim 1, 2 or 3, **characterised in that** a hollow cathode is inserted in the hollow body to be finished at its inner surface.

6. Process according to any one of the preceding claims, **characterised in that** cathode sputtering takes place, with particles being removed from the cathode surface of the hollow cathode, and that the particles are transported by the gas stream flowing through the hollow body to the inner surface of this body, where they are deposited.

7. Process according to any one of the preceding claims, **characterised in that** an additional gas reaches the inner surface of the hollow body by diffusion or as a flow, that constituents from the additional gas are deposited as a film or film constituent on the inner surface of the hollow body and diffuse into the inner surface or remove material from the inner surface, in so doing helping to finish the inner surface.

8. Process according to any one of the preceding claims, **characterised in that** the surface-finishing is effected by plasma particles and cathode material which is removed in particulate form.

9. Process according to any one of the preceding claims, **characterised in that** the hollow-cathode glow discharge is powered by d.c. voltage, pulsed d.c. voltage or a.c. voltage, with a frequency of essentially 1 kHz to 10 GHz and a voltage of essentially 200 V to 2 kV being provided in particular.

10. Process according to any one of the preceding claims, **characterised in that** the inner surface of the hollow body is placed at an electric potential which is negative with respect to the hollow-cathode plasma, in particular at a potential of essentially 10 V or a multiple thereof up to essentially 100 V or a multiple thereof.

11. Process according to claim 10, **characterised in that** positively charged particles are released from the hollow-cathode plasma or result from a non-self-maintained discharge supported by the hollow-cathode plasma, and that they are accelerated in the hollow body towards the inner surface thereof and reinforce the surface finish.

12. Process according to any one of the preceding claims, **characterised in that** the hollow body is heated or cooled during surface-finishing, or that the hollow cathode is cooled during surface-finishing.

13. Apparatus for carrying out the process according to any one of claims 1 to 12, **characterised in that** a hollow cathode, a gas supply, a vacuum vessel for holding the hollow cathode and at least a part of a hollow body to be coated, an anode, a current supply and in operation a plasma are provided.

14. Apparatus according to claim 13, **characterised in that** a gas stream flowing through the hollow body to be finished on its inner surface and an additional gas are provided.

15. Apparatus according to claim 13, **characterised in that** the hollow cathode is disposed inside the hollow body.

16. Apparatus according to claim 14 or 15, **characterised in that** the hollow cathode is disposed outside of the hollow body.

17. Apparatus according to any one of claims 13 to 16, **characterised in that** a heating device or a cooling device is provided for heating or cooling the hollow body during surface-finishing.

18. Apparatus according to any one of claims 13 to 16, **characterised in that** a cooling system is provided for the hollow cathode.

19. Apparatus according to any one of claims 13 to 18, **characterised in that** the gas flowing through the hollow cathode is an inert gas, in particular argon gas.

20. Apparatus according to any one of claims 13 to 19, **characterised in that** a pressure of essentially 0.1 mbar to approximately 100 mbar is provided in the vacuum vessel.

21. Apparatus according to any one of claims 13 to 20, **characterised in that** the hollow body to be finished has an inside diameter of 1 to 100 mm.

## Revendications

1. Procédé de traitement de surface pour des surfaces internes de corps creux ayant au moins un orifice, dans lequel le corps creux est traité de l'intérieur par une décharge à effet corona par cathode creuse servant de source d'excitation et des particules sont libérées par un courant gazeux traversant le corps creux à partir du plasma qui se forme lors de la décharge à effet corona, excitées et transportées sur la surface interne du corps creux où elles déclenchent le processus de traitement, le corps creux étant disposé dans un récipient sous vide et le corps creux et la cathode creuse formant des éléments séparés l'un de l'autre.

2. Procédé selon la revendication 1, **caractérisé en ce que** le traitement de surface se fait par un procédé de dépôt physique en phase vapeur (PVD) ou de dépôt chimique en phase vapeur (CVD) ou bien par diffusion de plasma ou par un procédé d'attaque au plasma ou ionique.

3. Procédé selon la revendication 1 ou la revendication 2, **caractérisé en ce que** l'on utilise un courant de gaz inerte comme moyen de transport pour des particules formant couche ou pour des particules réagissant sur la surface interne du corps creux.

4. Procédé selon l'une des revendications 1 à 3, **caractérisé en ce que** le corps creux dont la surface interne doit être traitée est exposé à la source d'excitation de la décharge à effet corona par cathode creuse et à une alimentation en gaz de telle façon que les particules du gaz traversant la cathode creuse parviennent dans le corps creux.

5. Procédé selon la revendication 1, la revendication 2 ou la revendication 3, **caractérisé en ce qu'**une cathode creuse est introduite dans le corps creux dont la surface interne doit être traitée.

6. Procédé selon l'une des revendications précédentes, **caractérisé en ce qu'**il se produit une pulvérisation cathodique, des particules étant arrachées de la surface de la cathode creuse, et **en ce que** les particules sont transportées par le courant de gaz traversant le corps creux sur la surface interne de ce dernier et s'y déposent.

7. Procédé selon l'une des revendications précédentes, **caractérisé en ce qu'**un gaz d'appoint parvient par diffusion ou écoulement sur la surface interne du corps creux, **en ce qu'**il se dépose sous forme de couche ou de composant de couche sur la surface interne de ce dernier des composants du gaz d'appoint qui pénètrent par diffusion dans la surface interne ou qui arrachent de la matière de la surface interne, contribuant ainsi au traitement de la surface interne.

8. Procédé selon l'une des revendications précédentes, **caractérisé en ce que** le traitement de surface est réalisé par des particules de plasma et du matériau de la cathode arraché par pulvérisation.

9. Procédé selon l'une des revendications précédentes, **caractérisé en ce que** la décharge à effet corona par cathode creuse est alimentée par une tension continue, une tension continue pulsée ou une tension alternative, notamment en fournissant une fréquence essentiellement dans la plage de 1 kHz à 10 GHz et une tension essentiellement dans la plage de 200 V à 2 kV.

10. Procédé selon l'une des revendications précédentes, **caractérisé en ce que** l'on applique à la surface interne du corps creux un potentiel électrique négatif par rapport au plasma de la cathode creuse, en particulier un potentiel essentiellement compris dans la plage de 10 V ou de multiples de cette valeur à 100 V ou des multiples de cette valeur.

11. Procédé selon la revendication 10, **caractérisé en ce que** des particules chargées positivement sont détachées du plasma de la cathode creuse ou produites par une décharge non autonome assistée par le plasma de la cathode creuse et **en ce que** ces particules sont accélérées dans le corps creux en direction de sa surface interne et renforcent le traitement de surface.

12. Procédé selon l'une des revendications précédentes, **caractérisé en ce que** le corps creux est chauffé ou refroidi pendant le traitement de surface ou **en ce que** la cathode creuse est refroidie pendant le traitement de surface.

13. Dispositif pour réaliser le procédé selon l'une des revendications 1 à 12, **caractérisé en ce qu'**il est prévu une cathode creuse, une alimentation en gaz, un récipient sous vide destiné à recevoir la cathode creuse et au moins une partie du corps creux à revêtir, une anode, une alimentation en courant électrique et, en fonctionnement, un plasma.

14. Dispositif selon la revendication 13, **caractérisé en ce qu'**il est prévu un courant de gaz traversant le corps creux dont la surface interne doit être traitée et un gaz d'appoint.

15. Dispositif selon la revendication 13, **caractérisé en ce que** la cathode creuse est disposée à l'intérieur du corps creux.

16. Dispositif selon la revendication 13 ou la revendication 14, **caractérisé en ce que** la cathode creuse est disposée à l'extérieur du corps creux.

17. Dispositif selon l'une des revendications 13 à 16, **caractérisé en ce qu'**il est prévu un dispositif de chauffage ou un dispositif de refroidissement pour chauffer ou refroidir le corps creux pendant le traitement de surface.

18. Dispositif selon l'une des revendications 13 à 16, **caractérisé en ce qu'**il est prévu un refroidissement pour la cathode creuse.

19. Dispositif selon l'une des revendications 13 à 18, **caractérisé en ce que** le gaz traversant la cathode creuse est un gaz inerte, en particulier du gaz argon.

20. Dispositif selon l'une des revendications 13 à 19, **caractérisé en ce qu'**il est prévu dans le récipient sous vide une pression essentiellement comprise dans la plage de 0,1 mbar à 100 mbar environ.

21. Dispositif selon l'une des revendications 13 à 20, **caractérisé en ce que** le corps creux à traiter présente un diamètre intérieur de 1 à 100 mm.
